# EUROPEAN PATENT APPLICATION

(11) **EP 4 838 292 A1**
(43) Date of publication of application: **11.11.2026**
(21) Application number: 25838638.2
(22) Date of filing: 05.08.2025
(51) Int. Cl.: G02C 7/06, G02B 1/118, G02B 1/18, G03F 7/00, G03F 7/16, G03F 7/20

(54) **LENS MANUFACTURING METHOD AND SYSTEM, PROGRESSIVE LENS, AND REPAIR METHOD**

(30) Priority: 18.07.2025 CN 202510993333
(71) Applicant: Nantong Nuotong Yimu Medical Technology Co., Ltd., Nantong, Jiangsu 226126 (CN)
(72) Inventor: CAI, Xiaogu, Nantong, Jiangsu 226126 (CN); DI, Make, Nantong, Jiangsu 226126 (CN); MO, Tuba, Beijing 100043 (CN)
(74) Representative: Vitina, Maruta
(86) International application number: PCT/CN2025/112736
(87) International publication number: WO 2026/051670

(57) **Abstract**

A lens manufacturing method, in which photoresists varying in refractive index are coated on a lens substrate; a photopolymerization reaction of the photoresists is induced by a laser beam emitted from a laser system to lithographically form at least two micro/nano structure sets varying in optical properties on the lens substrate, thereby obtaining a lens having the micro/nano structure sets arranged in a predetermined layout. The lens realizes a required refractive-index distribution through the micro/nano structure sets in the predetermined layout. A minimum feature size of the micro/nano structure sets is 50 nanometers. A lens manufacturing system, a progressive lens and a repair method are also provided.

## Description

### TECHNICAL FIELD

This application relates to lens manufacturing technology, and more particularly to a lens manufacturing method and system, a progressive lens, and a repair method.

### BACKGROUND

A progressive lens is a multi-focal lens, i.e., a single lens has a plurality of focal points. Through a multi-focal design, it can satisfy the visual needs of a wearer at different viewing distances (near to intermediate to far) and under different viewing environments. Because it can provide a seamless visual experience, enabling clear focusing from near to far, it is widely welcomed. Chinese Patent Application Publication No. 113334649A discloses a machine-manufacturing method for a full-field arc-shaped progressive lens, which includes: a first step of fixing the center of grinding outside a mold core so that an auxiliary sub-mold core fits with an original master mold core; a second step of grinding, by drawing circles, a required curvature using sub-mold cores of increasing radii, where the grinding range includes the original master mold core; and a third step of grinding and engraving within the radius range of the sub-mold core using the center of the sub-mold core as the center point.

However, such conventional progressive-lens manufacturing processes face various limitations, which are mainly reflected in the following aspects:
1. Processing-accuracy limitation: Conventional progressive lenses are mainly manufactured by mechanical grinding and polishing processes, which are difficult to achieve micrometer- or nanometer-level processing accuracy. Therefore, there are limitations in highly refined control of optical performance, especially in realizing complex refractive-index distributions.
2. Unsmooth refractive-index transition: Due to limitations of processing technology, the refractive-index change between different viewing zones of conventional progressive lenses is often not smooth enough, so that when a user switches from near viewing to far viewing, the user may feel a sudden visual change or discomfort.
3. Insufficient design and manufacturing flexibility: When designing and manufacturing progressive lenses, conventional processes are often constrained by physical grinding, which limits design freedom and innovation. In particular, for progressive lenses requiring personalized designs, it is difficult for existing technologies to meet requirements in cost and efficiency.
4. Low material utilization and cost issues: Mechanical grinding and polishing not only take a long processing time but also cause large material loss, especially for lenses made of high-refractive-index materials, resulting in relatively high costs. In addition, such processing methods may involve environmental pollution.
5. Difficulty in meeting user customization needs: With rising requirements for visual quality, demand for personalized lens designs is increasing. Conventional processes have limitations in meeting customization needs, particularly in precisely adjusting optical performance to match specific visual conditions.

### SUMMARY

In view of the defects in the prior art, an object of the disclosure is to provide a lens manufacturing method and system, a progressive lens, a detection system, and a repair method.

Technical solutions of the present disclosure are described as follows.

In a first aspect, this application provides a lens manufacturing method, comprising:
coating photoresists on a lens substrate; and
inducing, by a laser beam emitted from a laser system, a photopolymerization reaction of the photoresists to lithographically form micro/nano structure sets on the lens substrate, thereby obtaining a lens having the micro/nano structure sets arranged in a predetermined layout,
wherein the lens realizes a required refractive-index distribution through the micro/nano structure sets in the predetermined layout.

In some embodiments, the photoresists each have a two-photon absorption characteristic, and the lithography is two-photon lithography.

In some embodiments, a refractive index of each of the photoresists is between 1.5 and 1.9.

In some embodiments, a coating thickness of each of the photoresists is greater than or equal to 100 nm.

In some embodiments, the photoresists are each coated by spin coating, drop coating, or spray coating.

In some embodiments, before coating the photoresists, the method further comprises:
pre-treating a surface of the lens substrate, wherein the pre-treatment comprises cleaning, degreasing, or surface activation.

In some embodiments, after coating the photoresists, the method further comprises:
pre-curing the coated photoresists, wherein the pre-curing comprises thermal treatment to volatilize the photoresists, and an amount of volatilization is less than or equal to 40%.

In some embodiments, after lithography, the method further comprises:
post-treating the surface of the lens substrate, wherein the post-treatment comprises removing remaining photoresists on the lens substrate, adding an anti-reflection coating, adding a hydrophobic coating, or performing optical-performance inspection.

In some embodiments, a minimum feature size of the at least two micro/nano structure sets is 50 nanometers.

In some embodiments, the photoresists vary in refractive index, and are respectively coated on the lens substrate for photopolymerization to form at least two micro/nano structure sets varying in optical properties on the lens substrate.

In a second aspect, this application provides a progressive lens, comprising:
a lens substrate, and micro/nano structure setsformed on the lens substrate through photopolymerization;
wherein a required refractive-index distribution is realized through the micro/nano structure sets arranged in a predetermined layout.

In some embodiments, each of the micro/nano structure sets comprises optical waveguides or optical antennas.

In some embodiments, the micro/nano structure sets are designed to modulate a polarization state of light passing through the lens substrate to provide a polarization modulation function; or the micro/nano structure sets are designed to provide a temperature-responsive function of the lens substrate by changing a state of a temperature-sensitive material in the lens substrate to adjust the optical performance of the lens substrate.

In some embodiments, a surface of the progressive lens has a scratch-resistant coating, an ultraviolet-blocking coating, a blue-light filtering coating, a superhydrophobic coating, or a superoleophobic coating.

In some embodiments, a minimum feature size of the micro/nano structure sets is 50 nanometers.

In some embodiments, the micro/nano structures have one or more optical properties. In a third aspect, this application provides a lens manufacturing system, comprising:
a femtosecond laser;
a focusing optical system;
a three-dimensional motion stage;
a photoresist feeding device; and
a software for designing and simulating the micro/nano structures;
wherein the three-dimensional motion stage is configured to load and move a lens substrate and to drive the lens substrate to rotate;
the photoresist feeding device is configured to coat photoresists on the lens substrate;
the femtosecond laser is configured, according to a micro/nano-structure pattern provided by the software, to perform lithography on the lens substrate after the photoresists are coated, so as to obtain micro/nano structure sets varying in optical properties on the lens substrate, thereby realizing the required refractive-index distribution through the micro/nano structures; and
the focusing optical system is configured to control a scanning speed and focal length of a laser beam emitted by the femtosecond laser.

In a fourth aspect, this application provides a lens repair method, comprising:
performing local repair of damaged micro/nano structure sets on a lens using the above lens manufacturing method.

Compared to the prior art, the present disclosure has the following beneficial effects.
1. Precise control of optical performance: the micro/nano structure sets formed in the progressive lens can be controlled to the nanometer level, enabling more accurate adjustment of refractive index and greatly improving optical performance. Users can experience a smooth visual transition from near to far, reducing discomfort caused by refractive-index discontinuities.
2. Improved visual quality: by finely controlling internal structures, visual distortion and astigmatism can be effectively reduced, especially in the transition zone. Users can obtain a clearer and more stable visual experience when switching viewing distances.
3. Highly customized design capability: using two-photon micro/nano fabrication technology, personalized progressive lenses can be customized according to a user's specific visual needs and usage habits, significantly improving adaptation to specific working environments and daily comfort.
4. Expanded lens functionality: in addition to optimizing optical performance, by selecting photoresist materials with specific functions, additional functions such as UV protection and blue-light filtering can be added, further enhancing practical value and user experience.
5. Environmental friendliness and cost efficiency: compared with conventional physical grinding and polishing, two-photon micro/nano fabrication greatly reduces material waste and production cost. The dry process reduces chemical waste and is environmentally friendly, consistent with green manufacturing.
6. Enhanced durability and stability: stable micro/nano structure sets can be formed on the lens substrate, which are more resistant to temperature changes and physical wear, potentially providing longer service life and better durability than conventional lenses.
7. Improved anti-reflection and anti-fog performance: by designing specific micro/nano structures, an efficient anti-reflection layer can be formed on the surface of the lens substrate to reduce scattering and reflection, improving transmittance and clarity. The structures can also help control condensation and provide an anti-fog effect.
8. Fast-response manufacturing process: compared with conventional manufacturing, two-photon micro/nano fabrication can achieve rapid conversion from design to product, shortening the product development cycle, which is particularly suitable for rapid iteration and personalized production.
9. No need for expensive molds: unlike conventional lens production relying on specific molds, the flexibility of two-photon micro/nano fabrication allows switching among designs without additional molds or equipment modification, thereby reducing cost and improving efficiency.
10. Multifunctional integrated design: two-photon micro/nano fabrication enables multiple functions to be integrated into a single lens substrate, such as focusing, filtering, and self-repair, realizing innovative one-lens-multiple-functions designs to meet modern consumers' demand for high-tech eyewear.

### BRIEF DESCRIPTION OF THE DRAWINGS

By reading the following detailed description of the embodiments with reference to the accompanying drawings, other features, objectives, and advantages of the present disclosure will become more apparent.

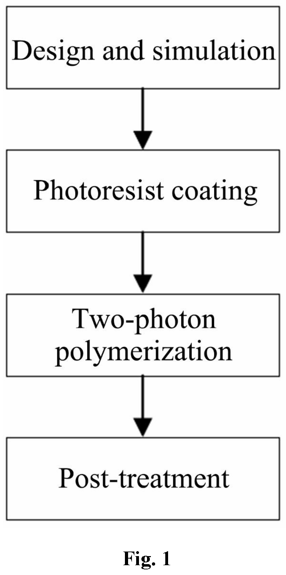

Fig. 1 is a workflow flowchart of a lens manufacturing method according to an embodiment of the present disclosure.

### DETAILED DESCRIPTION OF EMBODIMENTS

Specific embodiments of the present disclosure will be described below in conjunction with the drawing. The following embodiments help those skilled in the art further understand the present disclosure, but are not intended to limit the present disclosure in any form. It should be noted that various changes and modifications can be made by those of ordinary skill in the art without departing from the concept of the present disclosure, and such changes and modifications shall fall within the protection scope of the present disclosure.

### EMBODIMENT 1

As shown in Fig. 1, provided herein is a lens manufacturing method, including the following steps.

Design and simulation: optical design software is used to design a preliminary structure of a progressive lens according to requirements, so as to ensure that the lens design can achieve a seamless visual transition from near to far. Computer simulation technology is used to simulate light propagation through the lens to ensure that the designed micro/nano structure sets can achieve an expected refractive-index gradient and optical effect. For micro/nano structure sets, parameters such as length, width, height, and spacing of each micro/nano structure set can be defined in detail. During design, the overall shape and size of the lens are fully considered to ensure compatibility between the micro/nano structure sets and the lens. After simulation, the design file is converted into a scan-path file that can be recognized by the laser system. Two-photon micro/nano fabrication is used to achieve a minimum processing accuracy of 50 nanometers, enabling precise control of optical structures in the lens and optimization of light propagation paths. The lens substrate may have a concave surface on one side and a convex surface on the other side. The micro/nano structure sets may be arranged on the concave surface, on the convex surface, or on both the concave and convex surfaces.

Each of the micro/nano structure sets include a micropillar array structure and a gradient microlens structure. In a far-vision region of the lens, a micropillar array having substantially fixed height and diameter can be designed. By adjusting a material refractive index and an arrangement density of the micropillar array, a relatively stable dioptric power required in the far-vision region can be achieved. In a transition region and a near-vision region, the gradient microlenses are arranged. A radius of curvature of the microlenses gradually decreases from the far-vision region to the near-vision region, so as to achieve a smooth transition of dioptric power. For example, a diameter of each microlens can be controlled within 15-25 micrometers. By adjusting the height and curvature of the gradient microlenses, a refraction angle of light can be precisely controlled to satisfy vision correction requirements at different distances. For example, at an initial position of the transition region, a microlens height is 12 micrometers and a radius of curvature is 30 micrometers; in the near-vision region, the microlens height increases to 18 micrometers and the radius of curvature decreases to 20 micrometers. Distribution of each of the micro/nano structure sets includes axial distribution and radial distribution. Along a vertical direction of the lens (from the top to the bottom of the lens), an axial distribution design of each of the micro/nano structure set is performed according to a refractive-index distribution model simulated in advance. In the far-vision region, the micro/nano structure sets remain uniformly distributed. Upon entering the transition region, sizes and arrangement densities of the micro/nano structure sets vary according to a certain gradient function, such as a linear gradient function or an S-shaped gradient function, to ensure a smooth transition of dioptric power. In the near-vision region, a final distribution state of each of the micro/nano structure sets is determined according to near-vision correction needs. Considering that, in actual use, a user's line of sight is not always vertically downward and may move horizontally and obliquely, a reasonable distribution design is further performed in a radial direction (a horizontal direction with a lens center as a center). In a central region of the lens, each of the micro/nano structure sets is distributed relatively densely and uniformly to ensure clarity of central vision. Toward an edge region, the distribution gradually becomes sparser, and shapes and sizes of the micro/nano structure sets are slightly adjusted to compensate for aberrations caused by edge refraction, thereby ensuring good visual effect within the entire visible range of the lens.

Pre-treatment: a surface of the lens substrate is pre-treated, including cleaning, degreasing, or surface activation. For example, the lens substrate can first be cleaned with anhydrous ethanol to remove visible dust, particles, and other impurities. Then the lens substrate is placed into an ultrasonic cleaning machine containing an acetone solution. Acetone, as a commonly used organic solvent, has good dissolving capability for grease. The ultrasonic cleaning machine is set to a power of 50-100 W and a frequency of 40-60 kHz, and the cleaning time is 10-15 minutes. Under ultrasonic action, acetone can penetrate deeper into fine gaps and pores on the lens surface to thoroughly dissolve and strip grease. After cleaning, the lens substrate is taken out and rinsed 3-5 times with deionized water to remove residual acetone solution. Finally, a sodium hydroxide (NaOH) solution with a concentration of 5%-10% is prepared, and the rinsed lens is soaked therein. The NaOH solution can chemically react with molecules on the lens surface to generate more active groups and enhance adhesion between the photoresist and the lens. The soaking time is controlled at 5-10 minutes. Thereafter, the lens substrate is rinsed again with a large amount of deionized water to ensure that residual NaOH solution is completely removed. Finally, the lens is air-dried in a clean environment or dried with nitrogen. After such cleaning, degreasing, and surface activation, the subsequent photoresist coating step can effectively improve lithography quality and stability of the micro/nano structures. Photoresist coating: photoresists are coated on the lens substrate. The coating method is not limited to spin coating, drop coating, or spray coating. A coating thickness of each of the photoresists is greater than or equal to 100 nm. The photoresists selected are a photoresist having a two-photon absorption characteristic, and the refractive index of each of the photoresists is between 1.5 and 1.9 to satisfy different optical design needs. Such a refractive-index range can cover most visual applications and provides a wider design space for lenses. Taking spin coating as an example, the rotation speed of a spin coater is controlled at 1000-3000 rpm for 30-60 seconds. After coating, pre-curing is performed. The pre-curing includes thermal treatment to volatilize the photoresists, and the volatilization amount is less than or equal to 40%.

Two-photon polymerization: based on the scan-path file, the laser system causes the emitted laser beam to induce a photopolymerization reaction of the photoresists, so as to lithographically form micro/nano structure sets varying in optical properties on the lens substrate, thereby obtaining a lens having the micro/nano structure sets arranged in a predetermined layout. The lens realizes a required refractive-index distribution through the micro/nano structure sets in the predetermined layout. Specifically, the lens coated with the photoresists is placed on a high-precision stage of a two-photon lithography system. An optical positioning system is used for precise positioning and alignment of the lens. By adjusting the stage position, a processing region of the lens is ensured to fall within an effective scan range of a laser beam, and a lens center coincides with an origin of a scan coordinate system. According to the pre-designed layout of micro/nano structure sets, scan parameters including scan speed, scan path, and laser energy are input in control software. For example, the scan speed is generally controlled at 1-10 mm/s to ensure sufficient time for the photoresists to absorb two photons and undergo photopolymerization. During scanning, laser energy and spot size are monitored in real time to ensure stability. For complex micro/nano structure sets, a combination of layered scanning and spiral scanning may be adopted: first, a coarse scan defines an overall contour, and then a fine scan improves structural precision and surface quality. Post-treatment after lithography: the surface of the lens substrate is post-treated, including removing remaining photoresists on the lens substrate, adding an anti-reflection coating, adding a hydrophobic coating, or performing optical performance inspection. For example, after lithography, the lens is placed in a developer solution to remove unpolymerized photoresists. A developer matching the photoresists is selected. For a common positive photoresist, a tetramethylammonium hydroxide (TMAH) developer can be selected and diluted with deionized water at a ratio of 1:4. The lens is immersed in the developer for 3-5 minutes, while ultrasonic agitation is applied at a frequency of 40-60 kHz to accelerate development and ensure complete removal, avoiding adverse impact of residues on optical performance. After development, the lens is rinsed multiple times with deionized water to remove residual developer and impurities. Then the lens is immersed in an isopropanol solution for 1-2 minutes for dehydration. Finally, the lens is dried by nitrogen blowing or vacuum drying to ensure no water remains on the surface, avoiding water stains or oxidation. High-precision optical inspection equipment, such as an atomic force microscope (AFM) and a scanning electron microscope (SEM), is used to inspect micro-morphology of the micro/nano structures, including size accuracy, shape integrity, and surface roughness. An interferometer is used to measure surface-form accuracy, and a lensmeter is used to measure dioptric power in different regions. The inspection results are compared with design values. If size deviations, surface defects, or insufficient optical performance are found, lithography parameters can be adjusted or secondary lithography can be performed to optimize, ensuring that lens quality meets design requirements.

In the present disclosure, micro/nano structure sets on the lens substrate may have the same or different optical properties. To obtain micro/nano structure sets varying in optical properties, photoresists varying in refractive index may be coated on the lens substrate and photopolymerized to form at least two micro/nano structure sets varying in optical properties on the lens substrate.

### EMBODIMENT 2

A progressive lens can be prepared by the method of Embodiment 1, and includes a lens substrate and at least two micro/nano structure sets varying in optical properties, which are formed on the lens substrate through photopolymerization. The lens realizes the required refractive-index distribution through the micro/nano structure sets in a predetermined layout to provide a progressive visual effect. The lens may have micro/nano structure sets of one or more optical properties. For the micro/nano structure sets, parameters such as length, width, height, and spacing can be defined in detail. During design, the overall shape and size of the lens are fully considered to ensure compatibility between the micro/nano structure sets and the lens. After simulation, the design file is converted into a scan-path file that can be recognized by the laser system. Two-photon micro/nano fabrication is used to achieve a minimum processing accuracy of 50 nanometers, enabling precise control of optical structures in the lens and optimization of light propagation paths.

Each of the micro/nano structure sets includes a micropillar array structure and a gradient microlens structure. In a far-vision region of the lens, a micropillar array having substantially fixed height and diameter can be designed. By adjusting a material refractive index and an arrangement density of the micropillar array, a relatively stable dioptric power required in the far-vision region can be achieved. In a transition region and a near-vision region, the gradient microlenses structure are arranged. A radius of curvature of the gradient microlenses gradually decreases from the far-vision region to the near-vision region, so as to achieve a smooth transition of dioptric power. By adjusting the height and curvature of the gradient microlenses, a refraction angle of light can be precisely controlled to satisfy vision correction requirements at different distances.

Distribution of each of the micro/nano structure sets includes axial distribution and radial distribution. Along a vertical direction of the lens (from the top to the bottom of the lens), an axial distribution design is performed based on a simulated refractive-index distribution model. In the far-vision region, the micro/nano structure sets remain uniformly distributed. In the transition region, sizes and arrangement densities of the micro/nano structure sets vary according to a linear gradient function or an S-shaped gradient function to ensure a smooth transition of dioptric power. In the near-vision region, a final distribution state of each of the micro/nano structure sets is determined according to near-vision correction needs. Considering that, in actual use, a user's line of sight is not always vertically downward and may move horizontally and obliquely, a reasonable distribution design is performed in a radial direction (a horizontal direction with the lens center as a center). In a central region, the micro/nano structure sets are distributed relatively densely and uniformly to ensure central vision clarity. Toward an edge region, the distribution gradually becomes sparser, and shapes and sizes of the micro/nano structure sets are slightly adjusted to compensate for aberrations caused by edge refraction, thereby ensuring good visual effect within the entire visible range.

A surface of the progressive lens may have a scratch-resistant coating, an ultraviolet-blocking coating, a blue-light filtering coating, a superhydrophobic coating, or a superoleophobic coating. The lens surface may further integrate, through two-photon micro/nano fabrication, a miniature QR code or a holographic mark for data storage or authentication.

Taking a myopia lens as an example, micro/nano structure sets may be arranged on a concave surface of the lens in an array. The structure sets can change propagation and scattering characteristics of light through the lens, thereby adjusting contrast of light entering the eye to achieve a specific visual effect and physiological impact, which is beneficial for myopia control. Under the action of a plurality of uniformly distributed micro/nano structure sets, both contrast control and optical-path-difference (OPD) modulation can be realized.

The micro/nano structure sets are diffractive structures with nanoscale feature sizes that work based on the diffraction principle of light. Nanoscale diffractive structures have periodicity that can be precisely controlled at the nanoscale. Such periodic structures can generate specific diffraction effects on incident light. The period size is related to a target wavelength and is generally within a certain proportion range of the target wavelength, for example, within a range of 0.75λ to 3λ, where λ is the target wavelength.

In some embodiments, a defocus amount De of each of the micro/nano structure sets satisfies: +4.00 D ≤ De ≤ +10.00 D, where D represents diopters, and +10.00 D is an extreme defocus. Each of the gradient microlenses reaches the extreme defocus within a field angle of 8°. The defocus amount of each of the micro/nano structure sets is positively correlated with the field angle: the defocus amount increases as the field angle increases, and an effective defocus amount of a micro/nano-structure region is larger. This provides an ultra-low disturbance level, better compliance, and better control effect. By optimizing the defocus design, the present disclosure better conforms to physiological characteristics of the human eye, and provides better effects in the macular region and with enhanced effects.

In some embodiments, on the basis of array distribution, the micro/nano structure sets may also be layered stacked structures obtained by separately coating photoresists varying in refractive index and performing photopolymerization as described in Embodiment 1. The number of micro/nano structure sets on the lens exceeds 33,000. A large number of micro/nano structure sets are arranged per unit area to realize high-intensity optical path difference (OPD) modulation. In the embodiments of the present disclosure, it can be understood that a continuous ultra-low-disturbance defocus region is formed by more than 33,000 micro/nano structure sets. In contrast, conventional myopia-control lenses typically have relatively large microlenses with sizes of about 0.8 mm to 2 mm. The present disclosure significantly reduces the size of the micro/nano structure sets so that more micro/nano structure sets can be accommodated per unit area, thereby realizing high-intensity OPD modulation and further realizing contrast control.

In the present disclosure, each of the micro/nano structure sets include optical waveguides or optical antennas, and may further integrate organic light-emitting diodes (OLEDs) or other light sources to realize a self-emitting function for visual assistance in low-light environments.

In some embodiments, the micro/nano structure sets may be designed to modulate a polarization state of light passing through the lens substrate to provide a polarization modulation function; or the micro/nano structure sets may be designed to realize a temperature-responsive function of the lens substrate by changing a state of a temperature-sensitive material in the lens substrate to adjust optical performance. The micro/nano structure sets may also be designed as tunable optical elements, such as a tunable-focus lens or a grating, to adapt to a user's dynamic visual needs.

### EMBODIMENT 3

A lens manufacturing system includes a femtosecond laser, a focusing optical system, a three-dimensional motion stage, a photoresist feeding device, and a software for designing and simulating micro/nano structures. The three-dimensional motion stage is configured to load and move a lens substrate and to drive the lens substrate to rotate. The photoresist feeding device is configured to coat photoresists varying in refractive index on the lens substrate. The femtosecond laser is configured, according to a micro/nano-structure pattern provided by the software, to perform lithography on the lens substrate after the photoresists are coated, so as to obtain at least two micro/nano structure sets varying in optical properties on the lens substrate, thereby realizing a required refractive-index distribution through the micro/nano structures. The focusing optical system is configured to control scanning speed and focal length of the laser beam emitted by the femtosecond laser.

In other embodiments, the manufacturing system further includes real-time monitoring and quality inspection devices for monitoring the processing process and verifying optical performance of the lens.

### EMBODIMENT 4

A lens repair method includes using the lens manufacturing method of Embodiment 1 to locally repair damaged micro/nano structure sets on a lens.

In the description of the present disclosure, it should be understood that terms such as "upper", "lower", "front", "rear", "left", "right", "vertical", "horizontal", "top", "bottom", "inner", and "outer" indicate orientations or positional relationships based on the orientations or positional relationships shown in the drawings, and are only for convenience of describing the present disclosure and simplifying the description, rather than indicating or implying that a referenced device or element must have a particular orientation or be constructed and operated in a particular orientation. Therefore, such terms should not be construed as limitations on the present disclosure.

The specific embodiments of the present disclosure have been described above. It should be understood that the present disclosure is not limited to the specific embodiments described above. Those skilled in the art can make various changes or modifications within the scope of the claims, without affecting the substance of the present disclosure. In the absence of conflict, the embodiments of the present disclosure and features therein may be combined with each other in any manner.

## Claims

1. A lens manufacturing method, **characterized in that** the lens manufacturing method comprises:
coating photoresists on a lens substrate; and
inducing, by a laser beam emitted from a laser system, a photopolymerization reaction of the photoresists to lithographically form micro/nano structure sets on the lens substrate, thereby obtaining a lens having the micro/nano structure sets arranged in a predetermined layout, wherein the lens realizes a required refractive-index distribution through the micro/nano structure sets in the predetermined layout.

2. The lens manufacturing method according to claim 1, **characterized in that** the photoresists each have a two-photon absorption characteristic, and the lithography is two-photon lithography;
a refractive index of each of the photoresists is between 1.5 and 1.9;
a coating thickness of each of the photoresists is greater than or equal to 100 nm; and
the photoresists are each coated by spin coating, drop coating, or spray coating.

3. The lens manufacturing method according to claim 1, further comprising:
before coating the photoresists, pre-treating a surface of the lens substrate, wherein the pre-treatment comprises cleaning, degreasing, or surface activation;
after coating the photoresists, pre-curing the coated photoresists, wherein the pre-curing comprises thermal treatment to volatilize the photoresists, and an amount of volatilization is less than or equal to 40%; and
after lithography, post-treating a surface of the lens substrate, wherein the post-treatment comprises removing remaining first photoresist on the lens substrate, adding an anti-reflection coating, adding a hydrophobic coating, or performing optical-performance inspection.

4. The lens manufacturing method according to claim 1, **characterized in that** a minimum feature size of the micro/nano structure sets is 50 nanometers; and
the photoresists vary in refractive index, and are respectively coated on the lens substrate for photopolymerization to form at least two micro/nano structure sets varying in optical properties on the lens substrate.

5. A progressive lens, comprising:
a lens substrate; and
micro/nano structure sets formed on the lens substrate through photopolymerization;
wherein a required refractive-index distribution is realized through the micro/nano structure sets arranged in a predetermined layout.

6. The progressive lens according to claim 5, **characterized in that** each of the micro/nano structure sets comprises optical waveguides or optical antennas;
the micro/nano structure sets are designed to modulate a polarization state of light passing through the lens substrate to provide a polarization modulation function; or
the micro/nano structure sets are designed to realize a temperature-responsive function of the lens substrate by changing a state of a temperature-sensitive material in the lens substrate to adjust optical performance of the lens substrate.

7. The progressive lens according to claim 5, **characterized in that** a surface of the progressive lens has a scratch-resistant coating, an ultraviolet-blocking coating, a blue-light filtering coating, a superhydrophobic coating, or a superoleophobic coating.

8. The progressive lens according to claim 5, **characterized in that** a minimum feature size of the micro/nano structure sets is 50 nanometers; and
the micro/nano structure sets one or more optical properties.

9. A lens manufacturing system, comprising:
a femtosecond laser;
a focusing optical system;
a three-dimensional motion stage;
a photoresist feeding device; and
a software for micro/nano structure set design and simulation;
**characterized in that** the three-dimensional motion stage is configured to load and move a lens substrate and to drive the lens substrate to rotate;
the photoresist feeding device is configured to coat photoresists on the lens substrate;
the femtosecond laser is configured, according to a micro/nano-structure pattern provided by the software, to perform lithography on the lens substrate after the photoresists are coated, so as to obtain micro/nano structure sets corresponding to the micro/nano-structure pattern on the lens substrate, thereby realizing a required refractive-index distribution through the micro/nano structure sets; and
the focusing optical system is configured to control scanning speed and focal length of a laser beam emitted by the femtosecond laser.

10. A lens repair method, comprising:
performing local repair of damaged micro-nano structures on a lens using the lens manufacturing method according to any one of claims 1-4.
